# EUROPÄISCHE PATENTANMELDUNG

(11) **EP 0 625 589 A1**
(43) Veröffentlichungstag der Anmeldung: **23.11.1994**
(21) Anmeldenummer: 94107749.7
(22) Anmeldetag: 19.05.1994
(51) Int. Cl.: C23C 16/44, C30B 25/14

(54) **Reaktor für CVD-Behandlungen**

(30) Priorität: 20.05.1993 DE 4316919
(71) Anmelder: Strämke, Siegfried, Dr., D-52538 Selfkant (DE)
(72) Erfinder: Strämke, Siegfried, Dr., D-52538 Selfkant (DE)
(74) Vertreter: Selting, Günther, Dipl.-Ing.

(57) **Zusammenfassung**

Der Reaktor weist eine Behandlungskammer (15) auf, in der zahlreiche Einlaßöffnungen für ein gas- oder dampfförmiges Reaktionsfluid angeordnet sind. Zu jeweils einer Einlaßöffnung (23) ist mindestens eine Auslaßöffnung (24) derart angeordnet, daß die die Einlaßöffnung verlassende Strömung nach einer Strömungsumkehr in die zugehörige Auslaßöffnung (24) eintritt. Dadurch entstehen um den Umfang des Werkstücks (16) verteilt bogenförmige Strömungswege, wodurch die Werkstückoberfläche gleichmäßig bestrichen wird.

## Beschreibung

Die Erfindung betrifft einen Reaktor für CVD-Behandlungen von Werkstücken und insbesondere ein System, mit dem Fluide in die Behandlungskammer eines CVD-Reaktors eingespeist und wieder entfernt werden.

In einem CVD-Reaktor (CVD = Chemical Vapor Deposition) werden Werkstücke mit chemisch reagierenden Stoffen behandelt. Ein typisches Beispiel ist die Abscheidung von Titan-Nitrid (TiN), welches sich in der Gasphase aus TiCl₄ + N₂ + H₂ bildet. Diese Umsetzung kann unter Normaldruck erfolgen, wird jedoch vorzugsweise bei Unterdruck oder im Vakuum durchgeführt, wobei zusätzlich ein die chemische Dampfablagerung unterstützendes Niederdruck-Plasma erzeugt werden kann, das mit Gleichstromimpulsen oder durch Hoch- oder Höchstfrequenzen erzeugt wird, so wie dies in DE 33 22 341 C2 beschrieben ist.

Eine Schwierigkeit eines CVD-Prozesses besteht darin, eine gleichmäßige Abscheidung im Volumen der Behandlungskammer zu erreichen, da sich das Reaktandenfluid bei seinem Durchgang durch die Behandlungskammer aufgrund der chemischen Reaktion in seiner Zusammensetzung verändert. Üblicherweise erfolgt eine gerichtete Durchflutung der Behandlungskammer, d.h. das Reaktionsmittel wird in den Kopfbereich der Behandlungskammer eingeführt und im Fußbereich abgesaugt, oder es wird radial von der Seite eingeführt und zentral abgesaugt. Nachteilig ist bei diesen Systemen, daß die Bedingungen für optimale Reaktionen nur in einem begrenzten Reaktionsvolumen gegeben sind. Ferner wird bei zentraler Absaugung das nutzbare Volumen der Behandlungskammer durch Einbauten oder durch das Werkstück stark eingeschränkt.

Ein Reaktor, von dem der Oberbegriff des Patentanspruchs 1 ausgeht, ist bekannt aus EP 0 410 442 A1. Dieser Reaktor ist ein Parallelplattenreaktor zur CVD-Behandlung von dünnen Halbleiterscheiben. Der Reaktor weist eine zylindrische Kammer auf, die an den Stirnseiten durch zwei Platten begrenzt ist, die einen geringen Abstand voneinander haben. In der einen Stirnwand befinden sich Einlaßöffnungen für das Behandlungsgas und in der Umfangswand befinden sich Auslaßöffnungen. Durch Ventile, die in den Einlaßöffnungen und Auslaßöffnungen vorgesehen sind, kann die gegen die Oberfläche der Halbleiterscheibe gerichtete Strömung variiert werden, so daß wahlweise rotierende Strömungen, radial einwärts gerichtete Strömungen, radial auswärts gerichtete Strömungen oder Kombinationen solcher Strömungen über der Oberseite der Halbleiterscheibe erzeugt werden können. Dieses Prinzip ist jedoch auf die Behandlung flacher scheibenförmiger Werkstücke beschränkt.

Der Erfindung liegt die Aufgabe zugrunde, einen Reaktor für CVD-Behandlungen zu schaffen, bei dem eine gleichmäßige Verteilung des Reaktionsfluids über das Volumen der Behandlungskammer erreicht wird.

Die Lösung dieser Aufgabe erfolgt erfindungsgemäß mit den im Patentanspruch 1 angegebenen Merkmalen.

Der erfindungsgemäße Reaktor eignet sich insbesondere für Plasma-CVD-Behandlungen.

Mehrere Einlaßöffnungen sind übereinander in unterschiedlichen Höhen in vertikalen Reihen angeordnet und mehrere Auslaßöffnungen sind ebenfalls übereinander in vertikalen Reihen angeordnet. Die Höhe der Behandlungskammer ist größer als der Radius der Behandlungskammer. Es können dreidimensionale Werkstücke von allen Seiten behandelt werden.

Bei dem erfindungsgemäßen Reaktor ist jeweils einer Einlaßöffnung für den gas- oder dampfförmigen Reaktanden mindestens eine Auslaßöffnung zugeordnet, die derart angeordnet ist, daß die die Einlaßöffnung verlassende Strömung nach einer Strömungsumkehr von mehr als 90° in die zugehörige Auslaßöffnung eintritt. Durch die Realisierung einer Strömungsumkehr des Behandlungsfluids in der Behandlungskammer werden örtlich begrenzte Zirkulationsbereiche geschaffen. Die Behandlungskammer wird also nicht in axialer Richtung oder in Querrichtung durchströmt, sondern es entstehen zahlreiche Strömungsbögen, die von den Wänden der Behandlungskammer ausgehen und nahe der Einspeisungspunkte wieder in dieselbe Wand einmünden. Dadurch werden in sämtlichen Bereichen der Behandlungskammer optimale Anströmungen des Werkstücks mit dem Reaktionsmittel erreicht. Es entsteht eine gleichmäßig über die Werkstückoberfläche verteilte Dampfablagerung selbst bei komplexen Werkstückkonturen. Der Eintritt des Reaktionsfluids erfolgt an zahlreichen verteilt angeordneten Stellen durch die dort vorgesehenen Einlaßöffnungen. Der Druck, mit dem das Reaktionsfluid in die Behandlungskammer eintritt, und die Saugkraft, mit der die Absaugung des Reaktionsfluids erfolgt, sind so aufeinander abgestimmt, daß das Reaktionsfluid die Behandlungskammer nicht von einem Ende bis zum gegenüberliegenden Ende durchströmt, sondern eine Strömungsumkehr erfolgt. Das Werkstück, das im allgemeinen im Zentrum der Behandlungskammer angeordnet ist, wird von dem Reaktionsfluid sanft angeströmt und dieses wird anschließend nahezu in dieselbe Richtung, aus der die Anströmung erfolgte, abgesaugt.

Vorzugsweise sind die Einlaßöffnungen und/oder die Auslaßöffnungen in einer Haube angeordnet, die von einem Unterteil abnehmbar ist, um ein Werkstück in die Behandlungskammer einzubringen. Durch Integration der Einlaßöffnungen und/oder Auslaßöffnungen in die Haube kann der freie Zugang zu den Werkstücken beim Be- und Entladen des Reaktors erreicht werden.

Ferner ist es möglich, Einlaßöffnungen und/oder Auslaßöffnungen auch in den Stirnwänden der Behandlungskammer anzuordnen.

Bei komplexen Werkstücken oder Werkstückchargen kann es zweckmäßig sein, die Zu- oder Abfuhr des Reaktionsmittels während der Behandlung zu verändern. Hierfür kann beispielsweise die Einlaßvorrichtung und/oder die Auslaßvorrichtung relativ zum Werkstück rotieren.

Im folgenden werden unter Bezugnahme auf die Zeichnungen Ausführungsbeispiele der Erfindung näher erläutert.

Es zeigen:
- Fig. 1: einen Längsschnitt durch eine erste Ausführungsform des Reaktors,
- Fig. 2: einen Querschnitt entlang der Linie II-II von Fig. 1,
- Fig. 3: einen Querschnitt durch eine zweite Ausführungsform des Reaktors und
- Fig. 4: schematisch einen Längsschnitt durch eine dritte Ausführungsform des Reaktors.

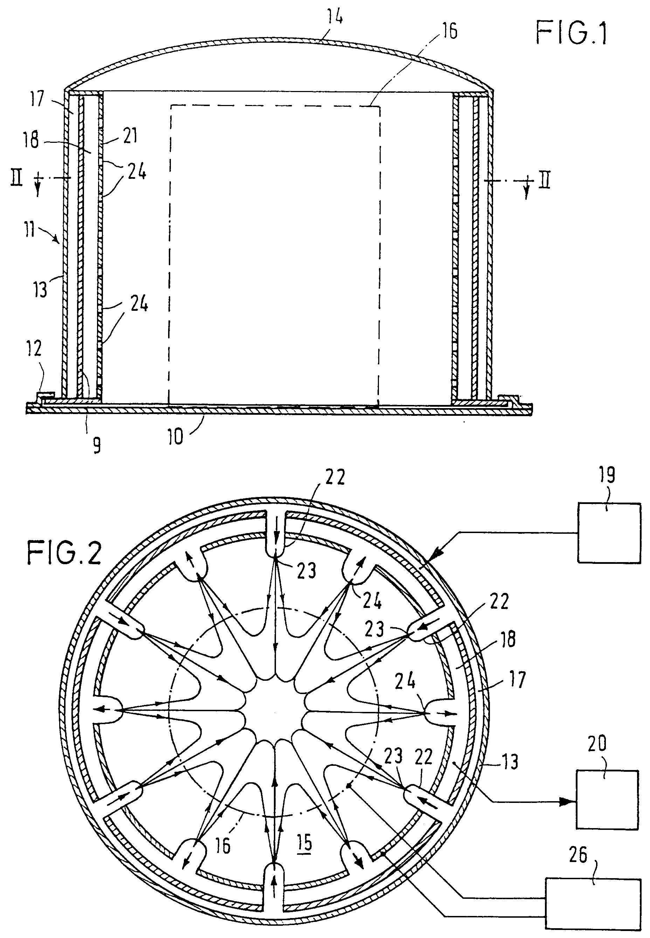

Bei dem Ausführungsbeispiel der Fign. 1 und 2 weist der Reaktor ein Unterteil 10 in Form einer Basisplatte auf, auf dem eine Haube 11 mit Schnellverschlüssen 12 abnehmbar befestigt ist. Die Haube 11 weist einen zylindrischen Mantel 13 und eine obere Stirnwand 14 auf. Zusammen mit dem Unterteil 10 begrenzt die Haube 11 die Behandlungskammer 15, in der ein Werkstück 16 angeordnet werden kann.

Der Mantel 13 umschließt zwei koaxiale Ringräume 17 und 18, die durch eine Trennwand 9 voneinander getrennt sind und um die Behandlungskammer 15 umlaufen. Der äußere Ringraum 17 ist an eine externe Lieferquelle 19 für das Behandlungsfluid angeschlossen und der innere Ringraum 18 ist an eine externe Saugquelle 20 angeschlossen. Die Saugquelle 20 dient dazu, die Behandlungskammer 15 zu evakuieren und anschließend das in die Behandlungskammer eingeleitete Behandlungsfluid abzusaugen.

Von dem äußeren Ringraum 17 führen radiale Vorsprünge 22 quer durch den Ringraum 18 hindurch in die Behandlungskammer 15 hinein. An den Enden dieser Vorsprünge 22 befinden sich Einlaßöffnungen 23 in Form von Löchern oder Schlitzen. An jedem Vorsprung 22 ist eine parallel zur Längsachse des Reaktors verlaufende Lochreihe von Einlaßöffnungen 23 angeordnet. Bei dem Ausführungsbeispiel der Fign. 1 und 2 sind über den Umfang der Behandlungskammer 15 gleichmäßig verteilt sechs Lochreihen von Einlaßöffnungen 23 vorgesehen. Zwischen jeweils zwei benachbarten Lochreihen von Einlaßöffnungen befindet sich eine Lochreihe von Auslaßöffnungen 24. Die Einlaßöffnungen 23 sind mit dem Ringraum 17 und die Auslaßöffnungen 24 mit dem Ringraum 18 verbunden.

Durch die Einlaßöffnungen 23 wird das Reaktionsfluid radial einwärts in die zylindrische Behandlungskammer 15 geblasen oder gesaugt. Dabei ergeben sich, wenn in der Behandlungskammer 15 kein Werkstück 16 enthalten ist, die in Fig. 2 dargestellten Strömungslinien. Das aus den Eintrittsöffnungen 23 in Richtung der Längsachse des Reaktors strömende Fluid wird nach entgegengesetzten Seiten hin seitlich von den benachbarten Auslaßöffnungen 24 angesaugt, so daß eine Strömungsumkehr von mehr als 90° entsteht, vorzugsweise von mehr als 135°. Jeder Eintrittsstrahl wird gewissermaßen nach entgegengesetzten Seiten hin abgesaugt, wobei die der Einlaßöffnung 23 benachbarten Auslaßöffnungen 24 nahe an der Einlaßöffnung 23 angeordnet und generell in dieselbe Richtung gerichtet sind wie die Einlaßöffnung.

Zur Erzeugung eines den CVD-Prozeß unterstützenden Plasmas ist die Innenwand 21 der Haube 11 mit dem einen Pol einer Spannungsquelle 26 verbunden. Der andere Pol der Spannungsquelle wird mit dem Werkstück 16 verbunden. Die Spannungsquelle 26 erzeugt Impulse, die zwischen der Innenwand 21 und dem Werkstück 16 eine Glimmentladung verursachen, wodurch in der Behandlungskammer 15 ein Plasma entsteht, das den Ablauf der chemischen Reaktion unterstützt.

Selbstverständlich kann das Plasma auch auf andere Weise, z.B. durch Hochfrequenz oder Mikrowellen, erzeugt werden.

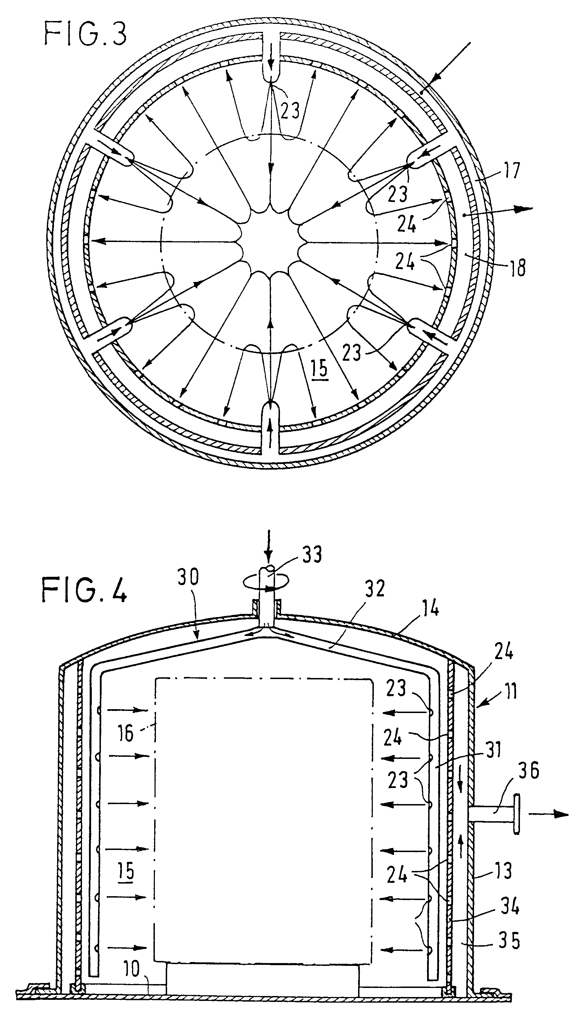

Das Ausführungsbeispiel von Fig. 3 entspricht weitgehend dem ersten Ausführungsbeispiel, jedoch mit dem Unterschied, daß zwischen zwei Reihen von Einlaßöffnungen 23 mehr als eine Reihe von Auslaßöffnungen 24 vorgesehen ist. Gemäß Fig. 3 sind zwischen benachbarten Reihen von Einlaßöffnungen 23 jeweils drei Reihen von Auslaßöffnungen 24 angeordnet.

Bei dem Ausführungsbeispiel von Fig. 4 sind die Einlaßöffnungen 23 an einer Einlaßvorrichtung 30 vorgesehen, die in der Haube 11 drehbar angeordnet ist und um die Längsachse der Haube herum rotieren kann. Die Einlaßvorrichtung 30 weist mehrere parallele Rohre 31 auf, an denen die Einlaßöffnungen 23 angeordnet sind. Jedes dieser Rohre 31 ist über ein Verbindungsrohr 32 mit einem Verteilerrohr 33 verbunden, das abdichtend in der Stirnwand 14 der Haube 11 gelagert ist und zugleich die Drehachse der Einlaßvorrichtung 30 bildet. Das Verteilerrohr 33 ist an die Lieferquelle angeschlossen und führt das Behandlungsfluid den Einlaßöffnungen 23 zu.

Die Auslaßöffnungen 24 sind an einer Innenwand 34 der Haube 11 angeordnet. Die Innenwand 34 begrenzt zusammen mit dem Mantel 13 einen Ringraum 35, der an einen mit der Saugquelle verbundenen Auslaß 36 angeschlossen ist.

Abweichend von Fig. 4 ist es auch möglich, eine rotierende Auslaßvorrichtung zu verwenden und die Einlässe in der Haube 11 feststehend anzuordnen. Darüber hinaus können auch die Einlaßvorrichtung und die Auslaßvorrichtung rotierend vorgesehen sein.

Die in die Behandlungskammer hineinführenden Einlaßöffnungen sind zweckmäßigerweise so gestaltet, daß sie keine gebündelten Fluidstrahlen erzeugen, sondern eine grobballige Turbulenz, damit unreagiertes Fluid auch in entfernt liegende und schwer zugängliche Bereiche gelangt.

In manchen Fällen kann es allerdings sinnvoll sein, mit sehr hohen Austrittsgeschwindigkeiten, z.B. > 10 m/s, zu arbeiten.

## Patentansprüche

1. Reaktor für CVD-Behandlungen von Werkstücken, mit einer gegen die Atmosphäre abgedichteten Behandlungskammer (15), die mehrere Einlaßöffnungen (23) und mehrere am Umfang verteilt angeordnete Auslaßöffnungen (24) für ein Reaktionsfluid aufweist, wobei zu jeweils einer Einlaßöffnung (23) mindestens eine Auslaßöffnung (24) derart angeordnet ist, daß die die Einlaßöffnung (23) verlassende Strömung nach einer Strömungsumkehr von mehr als 90° in die zugehörige Auslaßöffnung (24) eintritt,
**dadurch gekennzeichnet,**
daß auch die Einlaßöffnungen (23) am Umfang der Behandlungskammer (15) zwischen den Auslöffnungen (24) angeordnet sind, derart daß das Reaktionsfluid radial in die Behandlungskammer einströmt und nach Strömungsumkehr nahe der Einspeisungspunkte wieder abströmt.

2. Reaktor nach Anspruch 1, dadurch gekennzeichnet, daß neben mindestens einer Einlaßöffnung (23) mindestens zwei Auslaßöffnungen (24), zu beiden Seiten der Einlaßöffnung, vorgesehen sind.

3. Reaktor nach Anspruch 1 oder 2, dadurch gekennzeichnet, daß die Einlaßöffnungen (23) an eine gemeinsame Lieferquelle (19) und die Auslaßöffnungen (24) an eine gemeinsame Saugquelle (20) angeschlossen sind.

4. Reaktor nach einem der Ansprüche 1-3, dadurch gekennzeichnet, daß die Einlaßöffnungen (23) und/ oder die Auslaßöffnungen (24) in einer Haube (11) angeordnet sind, die von einem Unterteil (10) abnehmbar ist, um ein Werkstück (16) in die Behandlungskammer (15) einzubringen.

5. Reaktor nach einem der Ansprüche 1-4, dadurch gekennzeichnet, daß die Einlaßöffnungen (23) und/oder Auslaßöffnungen (24) an einem Schacht angeordnet sind, der mit einem abnehmbaren Deckel verschlossen ist.

6. Reaktor nach einem der Ansprüche 1-5, dadurch gekennzeichnet, daß in einer Umfangswand der Behandlungskammer (15) ein Ringraum (17) vorgesehen ist, der mit den Einlaßöffnungen (23) in Verbindung steht.

7. Reaktor nach einem der Ansprüche 1-6, dadurch gekennzeichnet, daß in einer Umfangswand der Behandlungskammer (15) ein Ringraum (18) vorgesehen ist, der mit den Auslaßöffnungen (24) in Verbindung steht.

8. Reaktor nach einem der Ansprüche 1-7, dadurch gekennzeichnet, daß die Einlaßöffnungen (23) an einer Einlaßvorrichtung (30) angeordnet sind, die in der Behandlungskammer (15) um das Werkstück (16) herum rotiert.

9. Reaktor nach einem der Ansprüche 1-8, dadurch gekennzeichnet, daß die Auslaßöffnungen (24) an einer Auslaßvorrichtung angeordnet sind, die in der Behandlungskammer (15) um das Werkstück (16) herum rotiert.

10. Reaktor nach einem der Ansprüche 1-9, dadurch gekennzeichnet, daß die Ausströmgeschwindigkeit im Auslaß größer ist als 10 m/s.
